# EUROPEAN PATENT APPLICATION

(11) **EP 4 492 452 A1**
(43) Date of publication of application: **15.01.2025**
(21) Application number: 24187937.8
(22) Date of filing: 11.07.2024
(51) Int. Cl.: H01L 23/367, H01L 23/373, H01L 25/07

(54) **POWER MODULE STRUCTURE**

(30) Priority: 12.07.2023 US 202363513176 P; 06.12.2023 CN 202311661683
(71) Applicant: Delta Electronics, Inc., Taoyuan City 33341 (TW)
(72) Inventor: SHIH, Fu-Yuan, 33341 Taoyuan City (TW); CHEN, Jung-Li, Taoyuan City (TW); CHI, Wei-Hao, 33341 Taoyuan City (TW); LEE, Wei-Yi, 33341 Taoyuan City (TW)
(74) Representative: 2K Patentanwälte Blasberg Kewitz & Reichel

(57) **Abstract**

A power module structure is provided. The power module structure includes a substrate, a copper layer, a metal layer, and a chip. The copper layer is disposed on the substrate. The metal layer is disposed on the copper layer. The area of the metal layer is smaller than that of the copper layer. The chip is disposed on the metal layer. The area of the chip is smaller than that of the metal layer.

## Description

### CROSS REFERENCE TO RELATED APPLICATIONS

This application claims priority to U.S. Provisional Application Serial Number 63/513,176, filed on July 12, 2023, and priority of China Patent Application No. 202311661683.0, filed on December 6, 2023, the entirety of which is incorporated by reference herein.

### BACKGROUND OF THE INVENTION

### Field of the Invention

The present disclosure relates to a power module structure, and, in particular, to a power module structure with metal thermal-conductive material which is installed under a chip.

### Description of the Related Art

Currently, the ceramic substrate in a power module is often used as a chip carrier. However, when a high-power chip is installed, local hot spots are easily generated in the underlying ceramic substrate, making it difficult for heat to dissipate.

### BRIEF SUMMARY OF THE INVENTION

In accordance with one embodiment of the present disclosure, a power module structure is provided. The power module structure includes a substrate, a copper layer, at least one metal layer, and at least one chip. The copper layer is disposed on the substrate. The metal layer is disposed on the copper layer. The area of the metal layer is smaller than that of the copper layer. The chip is disposed on the metal layer or on the substrate. Preferably, the area of the chip is smaller than that of the metal layer.

In some embodiments, the substrate includes aluminum oxide. In some embodiments, the metal layer includes copper, silver or aluminum. In some embodiments, the shape of the metal layer may be a rectangle, a circle, a polygon or a trapezoid. In some embodiments, the metal layer is in contact with the copper layer. In some embodiments, the chip includes a power component. In some embodiments, the chip is in contact with the metal layer.

In accordance with one embodiment of the present disclosure, the metal layer surrounds the chip. The area of the metal layer is smaller than that of the copper layer.

In some embodiments, the chip and the metal layer have different thicknesses. In some embodiments, the chip and the metal layer are in contact with the copper layer. In some embodiments, the chip is in contact with the metal layer.

In accordance with one embodiment of the present disclosure, the at least one metal layer comprises: a first metal layer and a second metal layer. The at least one chip comprises: a first chip and a second chip. The copper layer is disposed on the substrate. The first metal layer is disposed on the copper layer. The area of the first metal layer is smaller than that of the copper layer. The second metal layer is disposed on the copper layer. The area of the second metal layer is smaller than that of the copper layer. The second metal layer is separated from the first metal layer. The first chip is disposed on the first metal layer. The area of the first chip is smaller than that of the first metal layer. The second chip is disposed on the second metal layer. The area of the second chip is smaller than that of the second metal layer.

In some embodiments, the first metal layer and the second metal layer may be rectangular, circular, polygonal or trapezoidal in shape. In some embodiments, the first metal layer and the second metal layer have different shapes. In some embodiments, the first metal layer and the second metal layer have different thicknesses. In some embodiments, the first metal layer and the second metal layer are in contact with the copper layer. In some embodiments, the first chip is in contact with the first metal layer. In some embodiments, the second chip is in contact with the second metal layer.

Generally speaking, for an upper copper layer on a ceramic substrate, the etching ability of processes and warpage caused by thermal expansion need to be considered. Therefore, the thickness of the copper layer needs to be limited. However, when high-power chips are installed, local hot spots will be generated in the copper layer that is too thin, making it difficult for heat to dissipate. In the disclosed power module structure, an additional metal layer with high thermal conductivity and electrical conductivity is placed under (or around) the chip to partially thicken the copper layer on the substrate, which promotes heat to be evenly transferred on the metal layer first and expands the heat dissipation area, and then conducts more efficient heat transfer downwards. The disclosed metal layer is an accessory for the chip that amplifies its heat source. It can achieve uniform heat dissipation and increase the heat dissipation area, and is connected to the copper layer on the substrate.

In the present disclosure, the metal layer with an area larger than the heat source is utilized to contact the heat source, so that the temperature can be transferred evenly. The so-called uniform transfer means that there is a small temperature difference between the center point and the edge of the metal layer, that is, the metal layer tends to be isothermal (forming an uniform-temperature plate). In addition, the anti-bending strength of the substrate can be increased and the warpage of the substrate can be reduced through the bonding of the metal layer and the upper copper layer.

The disclosed metal layer can be locally thickened according to the circuit layout. Multiple metal layers can be provided on the copper layer at the same time. Each metal layer can be designed into different shapes and thicknesses according to product requirements.

In the present disclosure, the metal layer is added between the chip and the substrate so that the heat of the chip is evenly spread during the transfer process. In addition to avoiding the problem of local high temperature, it can also effectively increase the heat-dissipation area to cool down the chip. In summary, the advantages of the present disclosure include increasing the heat-dissipation effect of the chip, reducing the warpage of the substrate, elastically thickening the local copper layer, and saving the use of copper materials.

### BRIEF DESCRIPTION OF THE DRAWINGS

The disclosure can be more fully understood from the following detailed description when read with the accompanying figures. It is worth noting that in accordance with standard practice in the industry, various features are not drawn to scale. In fact, the dimensions of the various features may be arbitrarily increased or reduced for clarity of discussion.
FIG. 1 shows a cross-sectional view of a power module structure in accordance with one embodiment of the present disclosure;
FIG. 2A shows a three-dimensional view of a power module structure in accordance with one embodiment of the present disclosure;
FIG. 2B shows a three-dimensional view of a power module structure in accordance with one embodiment of the present disclosure;
FIG. 2C shows a three-dimensional view of a power module structure in accordance with one embodiment of the present disclosure;
FIG. 3 shows a three-dimensional view of a power module structure in accordance with one embodiment of the present disclosure; and
FIG. 4 shows a three-dimensional view of a power module structure in accordance with one embodiment of the present disclosure.

### DETAILED DESCRIPTION OF THE INVENTION

Various embodiments or examples are provided in the following description to implement different features of the present disclosure. The elements and arrangement described in the following specific examples are merely provided for introducing the present disclosure and serve as examples without limiting the scope of the present disclosure. For example, when a first component is referred to as "on a second component", it may directly contact the second component, or there may be other components in between, and the first component and the second component do not come in direct contact with one another.

It should be understood that additional operations may be provided before, during, and/or after the described method. In accordance with some embodiments, some of the stages (or steps) described below may be replaced or omitted.

In this specification, spatial terms may be used, such as "below", "lower", "above", "higher" and similar terms, for briefly describing the relationship between an element relative to another element in the figures. Besides the directions illustrated in the figures, the components may be used or operated in different directions. When the component is turned to different directions (such as rotated 45 degrees or other directions), the spatially related adjectives used in it will also be interpreted according to the turned position. In some embodiments of the present disclosure, terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

Herein, the terms "about", "around" and "substantially" typically mean a value is in a range of +/- 15% of a stated value, typically a range of +/- 10% of the stated value, typically a range of +/- 5% of the stated value, typically a range of +/- 3% of the stated value, typically a range of +/- 2% of the stated value, typically a range of +/- 1% of the stated value, or typically a range of +/- 0.5% of the stated value. The stated value of the present disclosure is an approximate value. Namely, the meaning of "about", "around" and "substantially" may be implied if there is no specific description of "about", "around" and "substantially".

It should be understood that, although the terms "first", "second", "third", etc. may be used herein to describe various elements, components, regions, layers, portions and/or sections, these elements, components, regions, layers, portions and/or sections should not be limited by these terms. These terms are only used to distinguish one element, component, region, layer, portion or section from another element, component, region, layer, portion or section. Thus, a first element, component, region, layer, portion or section discussed below could be termed a second element, component, region, layer, portion or section without departing from the teachings of the present disclosure.

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined.

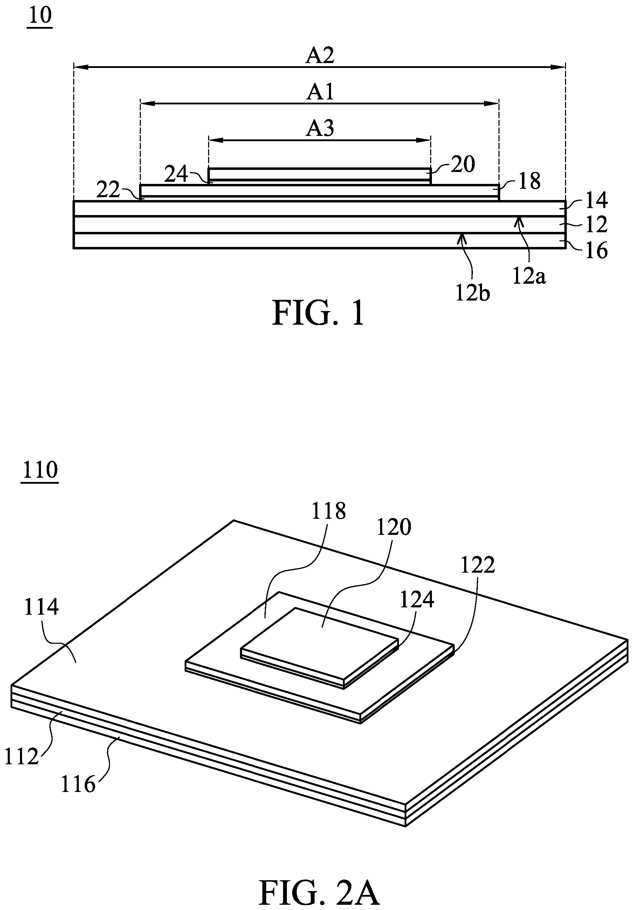

Referring to FIG. 1, in accordance with one embodiment of the present disclosure, a power module structure 10 is provided. FIG. 1 shows a cross-sectional view of the power module structure 10.

As shown in FIG. 1, the power module structure 10 includes a substrate 12, a first copper layer 14, a second copper layer 16, a metal layer 18, and a chip 20. The first copper layer 14 is disposed on the first surface 12a of the substrate 12. The second copper layer 16 is disposed on the second surface 12b of the substrate 12. The second surface 12b is opposite to the first surface 12a. The metal layer 18 is disposed on the first copper layer 14. The chip 20 is disposed on the metal layer 18. It is worth noting that the area A1 of the metal layer 18 is smaller than the area A2 of the first copper layer 14. The area A3 of the chip 20 is smaller than the area A1 of the metal layer 18.

In some embodiments, the material of the substrate 12 includes aluminum oxide, but the present disclosure is not limited thereto, and other suitable substrate materials are also applicable to the present disclosure. In some embodiments, when the material of the substrate 12 is aluminum oxide (i.e. ceramic material), the composite plate composed of the substrate 12, the first copper layer 14, and the second copper layer 16 is called a ceramic substrate. As a carrier for the chip 20, it has high thermal conductivity and electrical insulation properties.

In some embodiments, the material of the metal layer 18 includes metal materials with high thermal conductivity and electrical conductivity, such as copper, silver, or aluminum, but the present disclosure is not limited thereto, and other suitable metal materials are also applicable to the present disclosure. In some embodiments, the shape of the metal layer 18 includes a rectangle, a circle, a polygon, or a trapezoid, but the present disclosure is not limited thereto, and other suitable shapes of the metal layer are also applicable to the present disclosure. The shape of the metal layer 18 will be further described below with reference to the drawings (FIGS. 2A-2C).

In some embodiments, the metal layer 18 is in contact (e.g., bonded) with the first copper layer 14. In some embodiments, the metal layer 18 and the first copper layer 14 are bonded by soldering or diffusion bonding. In some embodiments, in the soldering, the metal layer 18 and the first copper layer 14 are bonded using solder paste 22.

In some embodiments, the chip 20 includes power components, such as high-power components.

In some embodiments, the chip 20 is in contact (e.g., bonded) with the metal layer 18. In some embodiments, the chip 20 and the metal layer 18 are bonded using silver paste 24. For example, the chip 20 and the metal layer 18 are bonded using non-pressure sintering silver.

Referring to FIG. 2A, in accordance with one embodiment of the present disclosure, a power module structure 110 is provided. FIG. 2A shows a three-dimensional view of the power module structure 110, mainly illustrating the shape of the metal layer in the power module structure 110.

As shown in FIG. 2A, the power module structure 110 includes a substrate 112, a first copper layer 114, a second copper layer 116, a metal layer 118, and a chip 120. The first copper layer 114 and the second copper layer 116 are disposed on two opposite surfaces of the substrate 112. The metal layer 118 is disposed on the first copper layer 114. The chip 120 is disposed on the metal layer 118. It can be seen from FIG. 2A that the area of the metal layer 118 is smaller than that of the first copper layer 114. The area of the chip 120 is smaller than that of the metal layer 118.

In some embodiments, the material of the substrate 112 includes aluminum oxide, but the present disclosure is not limited thereto, and other suitable substrate materials are also applicable to the present disclosure. In some embodiments, when the material of the substrate 112 is aluminum oxide (i.e. ceramic material), the composite plate composed of the substrate 112, the first copper layer 114, and the second copper layer 116 is called a ceramic substrate. As a carrier for the chip 120, it has high thermal conductivity and electrical insulation properties.

In some embodiments, the material of the metal layer 118 includes metal materials with high thermal conductivity and electrical conductivity, such as copper, silver, or aluminum, but the present disclosure is not limited thereto, and other suitable metal materials are also applicable to the present disclosure.

It is worth noting that in FIG. 2A, the shape of the metal layer 118 located under the chip 120 is a rectangle, but the present disclosure is not limited thereto, and other suitable shapes of the metal layer, such as circle, polygon, or trapezoid, are also applicable to the present disclosure.

In some embodiments, the metal layer 118 is in contact (e.g., bonded) with the first copper layer 114. In some embodiments, the metal layer 118 and the first copper layer 114 are bonded by soldering or diffusion bonding. In some embodiments, in the soldering, the metal layer 118 and the first copper layer 114 are bonded using solder paste 122.

In some embodiments, the chip 120 includes power components, such as high-power components.

In some embodiments, the chip 120 is in contact (e.g., bonded) with the metal layer 118. In some embodiments, the chip 120 and the metal layer 118 are bonded using silver paste 124. For example, the chip 120 and the metal layer 118 are bonded using non-pressure sintering silver.

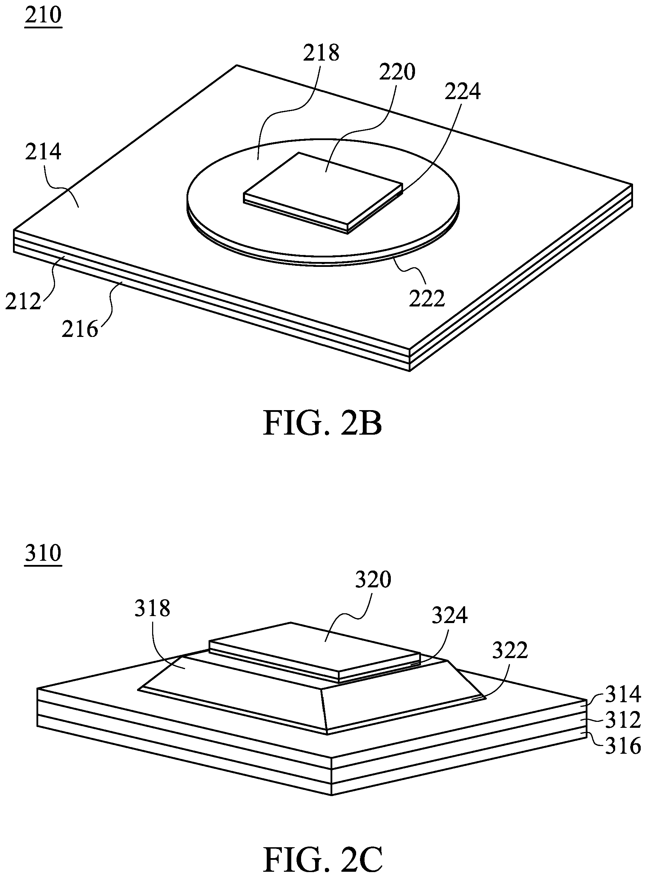

Referring to FIG. 2B, in accordance with one embodiment of the present disclosure, a power module structure 210 is provided. FIG. 2B shows a three-dimensional view of the power module structure 210, mainly illustrating the shape of the metal layer in the power module structure 210.

As shown in FIG. 2B, the power module structure 210 includes a substrate 212, a first copper layer 214, a second copper layer 216, a metal layer 218, a chip 220, solder paste 222, and silver paste 224. The configuration and material of each component, the dimensional relationship between the components, and the bonding manner between the components in the power module structure 210 shown in FIG. 2B are similar to those of the power module structure 110 shown in FIG. 2A, and will not be described again here. The main difference between the embodiment shown in FIG. 2B and the embodiment shown in FIG. 2A lies in the shape of the metal layer. In FIG. 2B, the shape of the metal layer 218 located under the chip 220 is a circle, but the present disclosure is not limited thereto, and other suitable shapes of the metal layer are also applicable to the present disclosure.

Referring to FIG. 2C, in accordance with one embodiment of the present disclosure, a power module structure 310 is provided. FIG. 2C shows a three-dimensional view of the power module structure 310, mainly illustrating the shape of the metal layer in the power module structure 310.

As shown in FIG. 2C, the power module structure 310 includes a substrate 312, a first copper layer 314, a second copper layer 316, a metal layer 318, a chip 320, solder paste 322, and silver paste 324. The configuration and material of each component, the dimensional relationship between the components, and the bonding manner between the components in the power module structure 310 shown in FIG. 2C are similar to those of the power module structure 110 shown in FIG. 2A, and will not be described again here. The main difference between the embodiment shown in FIG. 2C and the embodiment shown in FIG. 2A lies in the shape of the metal layer. In FIG. 2C, the shape of the metal layer 318 located under the chip 320 is a trapezoid, but the present disclosure is not limited thereto, and other suitable shapes of the metal layer are also applicable to the present disclosure.

As shown in FIG. 2C, when the shape of the metal layer 318 in the power module structure 310 is trapezoidal, the thermal diffusion area will gradually expand from the contact surface between the chip 320 and the metal layer 318 towards the first copper layer 314.

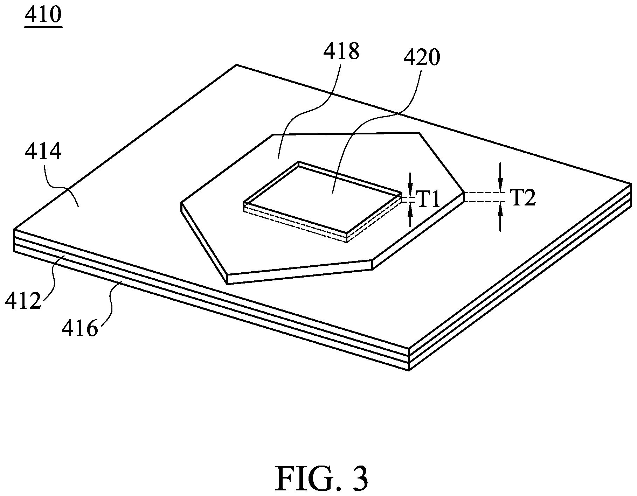

Referring to FIG. 3, in accordance with one embodiment of the present disclosure, a power module structure 410 is provided. FIG. 3 shows a three-dimensional view of the power module structure 410.

As shown in FIG. 3, the power module structure 410 includes a substrate 412, a first copper layer 414, a second copper layer 416, a metal layer 418, and a chip 420. The first copper layer 414 and the second copper layer 416 are disposed on two opposite surfaces of the substrate 412. The chip 420 is disposed on the first copper layer 414. The metal layer 418 is disposed on the first copper layer 414 and surrounds the chip 420. In addition, it can be seen from FIG. 3 that the area of the metal layer 418 is smaller than that of the first copper layer 414.

In some embodiments, the material of the substrate 412 includes aluminum oxide, but the present disclosure is not limited thereto, and other suitable substrate materials are also applicable to the present disclosure. In some embodiments, when the material of the substrate 412 is aluminum oxide (i.e. ceramic material), the composite plate composed of the substrate 412, the first copper layer 414, and the second copper layer 416 is called a ceramic substrate. As a carrier for the chip 420, it has high thermal conductivity and electrical insulation properties.

In some embodiments, the chip 420 includes power components, such as high-power components.

In some embodiments, the chip 420 is in contact (e.g., bonded) with the first copper layer 414. In some embodiments, the chip 420 and the first copper layer 414 are bonded using silver paste (not shown). For example, the chip 420 and the first copper layer 414 are bonded using non-pressure sintering silver.

In some embodiments, the material of the metal layer 418 includes metal materials with high thermal conductivity and electrical conductivity, such as copper, silver, or aluminum, but the present disclosure is not limited thereto, and other suitable metal materials are also applicable to the present disclosure. In addition, as shown in FIG. 3, the shape of the metal layer 418 surrounding the chip 420 in the power module structure 410 is a polygon, but the present disclosure is not limited thereto, and other suitable shapes of the metal layer, such as rectangle, circle, or trapezoid, are also applicable to the present disclosure.

In some embodiments, the metal layer 418 is in contact (e.g., bonded) with the first copper layer 414. In some embodiments, the metal layer 418 and the first copper layer 414 are bonded by soldering or diffusion bonding. In some embodiments, in the soldering, the metal layer 418 and the first copper layer 414 are bonded using solder paste (not shown).

In some embodiments, the thickness T1 of the chip 420 is the same as the thickness T2 of the metal layer 418. In some embodiments, the thickness T1 of the chip 420 is different from the thickness T2 of the metal layer 418. For example, the thickness T1 of the chip 420 is less than the thickness T2 of the metal layer 418, as shown in FIG. 3, or the thickness T1 of the chip 420 is greater than the thickness T2 of the metal layer 418 (not shown).

In some embodiments, the chip 420 is in contact with the metal layer 418, as shown in FIG. 3.

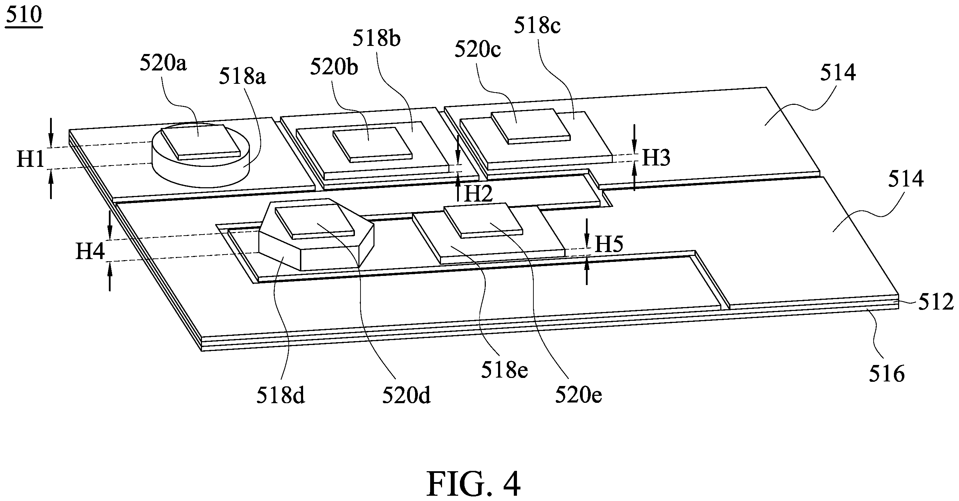

Referring to FIG. 4, in accordance with one embodiment of the present disclosure, a power module structure 510 is provided. FIG. 4 shows a three-dimensional view of the power module structure 510.

As shown in FIG. 4, the power module structure 510 includes a substrate 512, a first copper layer 514, a second copper layer 516, a plurality of metal layers (for example, a first metal layer 518a, a second metal layer 518b, a third metal layer 518c, a fourth metal layer 518d, and a fifth metal layer 518e), and a plurality of chips (a first chip 520a, a second chip 520b, a third chip 520c, a fourth chip 520d, and a fifth chip 520e). The first copper layer 514 and the second copper layer 516 are disposed on two opposite surfaces of the substrate 512. The first metal layer 518a, the second metal layer 518b, the third metal layer 518c, the fourth metal layer 518d, and the fifth metal layer 518e are respectively disposed on the first copper layer 514 and separated from each other. The first chip 520a is disposed on the first metal layer 518a, the second chip 520b is disposed on the second metal layer 518b, the third chip 520c is disposed on the third metal layer 518c, the fourth chip 520d is disposed on the fourth metal layer 518d, and the fifth chip 520e is disposed on the fifth metal layer 518e. It can be seen from FIG. 4 that the areas of the first metal layer 518a, the second metal layer 518b, the third metal layer 518c, the fourth metal layer 518d, and the fifth metal layer 518e are respectively smaller than the area of the first copper layer 514. The area of the first chip 520a is smaller than the area of the first metal layer 518a, the area of the second chip 520b is smaller than the area of the second metal layer 518b, the area of the third chip 520c is smaller than the area of the third metal layer 518c, the area of the fourth chip 520d is smaller than the area of the fourth metal layer 518d, and the area of the fifth chip 520e is smaller than the area of the fifth metal layer 518e.

In some embodiments, the material of the substrate 512 includes aluminum oxide, but the present disclosure is not limited thereto, and other suitable substrate materials are also applicable to the present disclosure. In some embodiments, when the material of the substrate 512 is aluminum oxide (i.e. ceramic material), the composite plate composed of the substrate 512, the first copper layer 514, and the second copper layer 516 is called a ceramic substrate. As a carrier for the first chip 520a, the second chip 520b, the third chip 520c, the fourth chip 520d, and the fifth chip 520e, it has high thermal conductivity and electrical insulation properties.

In some embodiments, the materials of the first metal layer 518a, the second metal layer 518b, the third metal layer 518c, the fourth metal layer 518d, and the fifth metal layer 518e include metal materials with high thermal conductivity and electrical conductivity, such as copper, silver, or aluminum, but the present disclosure is not limited thereto, and other suitable metal materials are also applicable to the present disclosure. In some embodiments, the shapes of the first metal layer 518a, the second metal layer 518b, the third metal layer 518c, the fourth metal layer 518d, and the fifth metal layer 518e include rectangle, circle, polygon, or trapezoid, but the present disclosure is not limited thereto, and other suitable shapes of the metal layer are also applicable to the present disclosure. In some embodiments, the shapes of the first metal layer 518a, the second metal layer 518b, the third metal layer 518c, the fourth metal layer 518d, and the fifth metal layer 518e are the same. In some embodiments, the shapes of the first metal layer 518a, the second metal layer 518b, the third metal layer 518c, the fourth metal layer 518d, and the fifth metal layer 518e are different. In some embodiments, the shapes of the first metal layer 518a, the second metal layer 518b, the third metal layer 518c, the fourth metal layer 518d, and the fifth metal layer 518e are partly the same and partly different. For example, the shape of the first metal layer 518a is a circle, the shape of the second metal layer 518b is a rectangle, the shape of the third metal layer 518c is a rectangle, the shape of the fourth metal layer 518d is a polygon, and the shape of the fifth metal layer 518e is a rectangle, as shown in FIG. 4.

In some embodiments, the first metal layer 518a, the second metal layer 518b, the third metal layer 518c, the fourth metal layer 518d, and the fifth metal layer 518e are respectively in contact (e.g., bonded) with the first copper layer 514. In some embodiments, the first metal layer 518a, the second metal layer 518b, the third metal layer 518c, the fourth metal layer 518d, and the fifth metal layer 518e are respectively bonded with the first copper layer 514 by soldering or diffusion bonding. In some embodiments, in the soldering, the first metal layer 518a, the second metal layer 518b, the third metal layer 518c, the fourth metal layer 518d, and the fifth metal layer 518e are respectively bonded with the first copper layer 514 by solder paste (not shown).

In some embodiments, the first chip 520a, the second chip 520b, the third chip 520c, the fourth chip 520d, and the fifth chip 520e include power components, such as high-power components.

In some embodiments, the first chip 520a is in contact (e.g., bonded) with the first metal layer 518a, the second chip 520b is in contact (e.g., bonded) with the second metal layer 518b, the third chip 520c is in contact (e.g., bonded) with the third metal layer 518c, the fourth chip 520d is in contact (e.g., bonded) with the fourth metal layer 518d, and the fifth chip 520e is in contact (e.g., bonded) with the fifth metal layer 518e. In some embodiments, the chips and the metal layers are bonded using silver paste (not shown). For example, the chips and the metal layers are bonded using non-pressure sintering silver.

In some embodiments, the first metal layer 518a, the second metal layer 518b, the third metal layer 518c, the fourth metal layer 518d, and the fifth metal layer 518e have the same thickness. In some embodiments, the first metal layer 518a, the second metal layer 518b, the third metal layer 518c, the fourth metal layer 518d, and the fifth metal layer 518e have different thicknesses. In some embodiments, the thicknesses of the first metal layer 518a, the second metal layer 518b, the third metal layer 518c, the fourth metal layer 518d, and the fifth metal layer 518e are partly the same and partly different. For example, the thickness H1 of the first metal layer 518a is the same as the thickness H4 of the fourth metal layer 518d. The thickness H2 of the second metal layer 518b is the same as the thickness H3 of the third metal layer 518c and the thickness H5 of the fifth metal layer 518e. The thickness H1 of the first metal layer 518a is different from the thickness H2 of the second metal layer 518b, the thickness H3 of the third metal layer 518c, and the thickness H5 of the fifth metal layer 518e, as shown in FIG. 4.

Generally speaking, for an upper copper layer on a ceramic substrate, the etching ability of processes and warpage caused by thermal expansion need to be considered. Therefore, the thickness of the copper layer needs to be limited. However, when high-power chips are installed, local hot spots will be generated in the copper layer that is too thin, making it difficult for heat to dissipate. In the disclosed power module structure, an additional metal layer with high thermal conductivity and electrical conductivity is placed under (or around) the chip to partially thicken the copper layer on the substrate, which promotes heat to be evenly transferred on the metal layer first and expands the heat dissipation area, and then conducts more efficient heat transfer downwards. The disclosed metal layer is an accessory for the chip that amplifies its heat source. It can achieve uniform heat dissipation and increase the heat dissipation area, and is connected to the copper layer on the substrate.

In the present disclosure, the metal layer with an area larger than the heat source is utilized to contact the heat source, so that the temperature can be transferred evenly. The so-called uniform transfer means that there is a small temperature difference between the center point and the edge of the metal layer, that is, the metal layer tends to be isothermal (forming an uniform-temperature plate). In addition, the anti-bending strength of the substrate can be increased and the warpage of the substrate can be reduced through the bonding of the metal layer and the upper copper layer.

The disclosed metal layer can be locally thickened according to the circuit layout. Multiple metal layers can be provided on the copper layer at the same time. Each metal layer can be designed into different shapes and thicknesses according to product requirements.

In the present disclosure, the metal layer is added between the chip and the substrate so that the heat of the chip is evenly spread during the transfer process. In addition to avoiding the problem of local high temperature, it can also effectively increase the heat-dissipation area to cool down the chip. In summary, the advantages of the present disclosure include increasing the heat-dissipation effect of the chip, reducing the warpage of the substrate, elastically thickening the local copper layer, and saving the use of copper materials.

Although some embodiments of the present disclosure and their advantages have been described in detail, it should be understood that various changes, substitutions and alterations can be made herein without departing from the spirit and scope of the disclosure as defined by the appended claims. The features of the various embodiments can be used in any combination as long as they do not depart from the spirit and scope of the present disclosure. Moreover, the scope of the present application is not intended to be limited to the particular embodiments of the process, machine, manufacture, composition of matter, means, methods and steps described in the specification. As one of ordinary skill in the art will readily appreciate from the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods or steps. In addition, each claim constitutes an individual embodiment, and the claimed scope of the present disclosure includes the combinations of the claims and embodiments. The scope of protection of present disclosure is subject to the definition of the scope of the appended claims. Any embodiment or claim of the present disclosure does not need to meet all the purposes, advantages, and features disclosed in the present disclosure.

## Claims

1. A power module structure, comprising:
a substrate (12,112,212,312; 412; 512);
a copper layer (14,114,214,314; 414) disposed on the substrate (12,112,212,312; 412);
at least one metal layer (18,118,218,318; 418; 518a, 518b) disposed on the copper layer (14,114,214,314; 414), wherein the metal layer (18,118,218,318; 418) has a smaller area (A1) than that (A2) of the copper layer (14,114,214,314; 414); and
at least one chip (20,120,220,320; 420; 520a, 520b) disposed on the metal layer (18,118,218,318; 418; 518a, 518b) or on the substrate (12,112,212,312; 412; 512).

2. The power module structure as claimed in claim 1, wherein the chip (20,120,220,320) has a smaller area (A3) than that (A1) of the metal layer (18,118,218,318).

3. The power module structure as claimed in claim 1 or 2, wherein the metal layer (18,118,218,318) comprises a rectangle, a circle, a polygon or a trapezoid in shape.

4. The power module structure as claimed in one of claims 1-3, wherein the metal layer (18,118,218,318) is in contact with the copper layer (14,114,214,314); and/or
wherein the chip (20,120,220,320) is in contact with the metal layer (18,118,218,318).

5. The power module structure as claimed in one of the preceding claims,whereinthe metal layer (418) is surrounding the chip (420).

6. The power module structure as claimed in claim 5, wherein the chip (420) and the metal layer (418) have different thicknesses (T1,T2).

7. The power module structure as claimed in claim 5 or 6, wherein the chip (420) and the metal layer (418) are in contact with the copper layer (414).

8. The power module structure as claimed in one of claims 5-7, wherein the chip (420) is in contact with the metal layer (418).

9. The power module structure as claimed in one of the preceding claims,wherein the at least one metal layer comprises:a first metal layer (518a) disposed on the copper layer (514), wherein the first metal layer (518a) has a smaller area than that of the copper layer (514); and
a second metal layer (518b) disposed on the copper layer (514), wherein the second metal layer (518b) has a smaller area than that of the copper layer (514), and the second metal layer (518b) is separated from the first metal layer (518a);
and wherein the at least one chip comprises:
a first chip (520a) disposed on the first metal layer (518a), wherein the first chip (520a) has a smaller area than that of the first metal layer (518a); and
a second chip (520b) disposed on the second metal layer (518b), wherein the second chip (520b) has a smaller area than that of the second metal layer (518b).

10. The power module structure as claimed in claim 9, wherein the first metal layer (518a) and the second metal layer (518b) comprise a rectangle, a circle, a polygon or a trapezoid in shape.

11. The power module structure as claimed in claim 9 or 10, wherein the first metal layer (518a) and the second metal layer (518b) have different shapes.

12. The power module structure as claimed in one of claims 9-11, wherein the first metal layer (518a) and the second metal layer (518b) have different thicknesses (H1,H2).

13. The power module structure as claimed in one of claims 9-12, wherein the first metal layer (518a) and the second metal layer (518b) are in contact with the copper layer (514) .

14. The power module structure as claimed in one of claims 9-13, wherein the first chip (520a) is in contact with the first metal layer (518a).

15. The power module structure as claimed in one of claims 9-14, wherein the second chip (520b) is in contact with the second metal layer (518b).
